# EUROPÄISCHE PATENTSCHRIFT

(11) **EP 0 682 264 B1**
(45) Veröffentlichungstag und Bekanntmachung des Hinweises auf die Patenterteilung: **28.07.1999**
(21) Anmeldenummer: 95106294.2
(22) Anmeldetag: 27.04.1995
(51) Int. Cl.: G01R 31/28, G01R 31/00

(54) **Verfahren zur Bewertung der passiven EMV-Eigenschaften von integrierten Schaltungen und Anordnung zur Durchführung des Verfahrens**
Procedure for determining the passive emi-qualities of integrated circuits and appliance for executing the procedure
Procédé pour déterminer les qualités de tolérance électromagnétique passives de circuits intégrés et dispositif pour élaborer ce procédé

(30) Priorität: 14.05.1994 DE 4417031
(43) Veröffentlichungstag der Anmeldung: 15.11.1995
(73) Patentinhaber: Langer, Gunter, D-01728 Bannewitz (DE)
(72) Erfinder: Langer, Gunter, D-01728 Bannewitz (DE)
(74) Vertreter: Heyner, Klaus, Dr.-Ing.

(56) Entgegenhaltungen:
- EP-A- 0 490 116
- DE-A- 4 212 751
- DE-A- 4 224 858
- DE-A- 4 225 858
- DE-A- 4 237 828
- DE-C- 4 110 752
- PATENT ABSTRACTS OF JAPAN vol. 5, no. 191 (P-92) [863] , 5.Dezember 1981 & JP 56 115965 A (FUJITSU), 11.September 1981,
- PATENT ABSTRACTS OF JAPAN vol. 6, no. 162 (P-137) [1040] , 25.August 1982 & JP 57 080577 A (MITSUBISHI), 20.Mai 1982,

## Beschreibung

Die Erfindung bezieht sich auf ein Verfahren zur Bewertung der EMV-Eigenschaften von integrierten Schaltungen (IC) und auf eine Anordnung zur Durchführung dieses Verfahrens. Die Erfindung ermöglicht den Vergleich von IC-EMV-Eigenschaften untereinander, wobei die IC an einem definierten Einbauort mit definierter Schaltfunktion betrieben werden.

Es ist bekannt, daß IC eine unterschiedliche Empfindlichkeit gegenüber Störbeeinflussung besitzen. Besonders hoch ist die Empfindlichkeit gegenüber impulsförmigen Beeinflussungen. So sind z.B. Schaltungen bzw. Geräte, die aus Standard CMOS aufgebaut sind, unempfindlicher bzw. robuster gegen Störbeeinflussung als Schaltungen, die mit schnelleren IC bestückt sind, wie z.B. mit HCMOS, ALS oder F. Der Fachwelt ist bekannt, daß diese Eigenschaft von der Schaltgeschwindigkeit der IC abhängig ist. CMOS sind langsamer als HCMOS und demzufolge unempfindlicher. Die Mechanismen, die die IC beeinflussen, sind nicht bekannt.

Zur Ermittlung der Störbeeinflussung von IC sind bereits verschiedene Verfahren und Schaltungsanordnungen bekannt. So wird in EP-A-0490116 eine Lösung beschrieben, bei der unter Verwendung eines induktionsarmen Widerstandes, einer Ersatzbeschaltung für den IC und einer allseitig abschirmenden Box reproduzierbare Meßwerte zur Beurteilung der EMV gewonnen werden können.

Mit DE-A-4212751 wird eine Vorgehensweise entwickelt, um einfache optische Übertragungssysteme zu verwenden und trotzdem Spikes einzufangen und phasenrichtig sowie logisch richtig zu übertragen. Durch eine Schaltung mit zwei hintereinander angeordneten RS-Flipflops und einer Rückführung des Ausgangssignals an den negierenden Rücksetzeingang des ersten RS-Flipflops über ein RC-Glied werden Spikes oder Impulszüge gedehnt und damit die übertragbare Grenzfrequenz heraufgesetzt.

Gegenstand von DE-A-4224858 ist ein Verfahren und eine Anordnung zur Bestimmung der elektromagnetischen Verträglichkeit (EMV) unter Verwendung von Störgeneratoren, die in geeigneter Weise betrieben und mit dem zu prüfenden Gerät bzw. der auszumessenden Schaltung verbunden werden.
Mit den von einem Störgenerator kontinuierlich oder in Zyklen erzeugten Störimpulsen wird die zu prüfende Schaltung beaufschlagt. Die Zahl der Überschreitungen der Störschwelle pro Zeiteinheit wird von einem Zähler als Zahlenwert angezeigt, wobei dieser Zahlenwert ein direktes Maß für die EMV ist.

Die IC-Anwender, d.h. Gerätehersteller, vergleichen nur in seltenen Fällen das Verhalten von IC unterschiedlicher Hersteller in den Anwendungsschaltungen ihrer Geräte. Das geschieht indem das Geräteverhalten mit verschiedenen IC-Bestückungen unter Störeinfluß untersucht wird. Im Gerät ist dabei der betreffende IC auf einer Leiterkarte bestückt, so wie es die Anwendung vorsieht. Für den Vergleich wird ein IC eines definierten Einbauortes gegen den gleichen IC-Typ eines anderen Herstellers ausgetauscht. Das so vorbereitete Gerät wird dann einer EMV-Prüfung unterzogen. Die bei der Prüfung auftretenden Gerätefunktionsfehler werden bezüglich der verschiedenen IC verglichen. Aus den Ergebnissen wird auf den robustesten IC geschlossen.

Der Prüfaufwand ist sehr hoch. Die Ergebnisse sind nicht allgemeingültig, da sie von den Schaltungs- und Geräteeigenschaften abhängig sind. Weiterhin ist die statistische Sicherheit der Ergebnisse schwer erfaßbar. Die verwendeten Störgeneratoren (Burstgeneratoren, ESD-Generatoren) besitzen eine relativ geringe Impulsrate. Die Störimpulse treffen zu selten kritische Phasen der IC-Funktion (z.B. Zeitpunkt der Informationsübernahme beim Lesen des Programms aus dem ROM). In einer solchen Phase ist eine EMV-empfindliche Funktion des betrachteten Schaltkreises (IC) aktiviert. Der IC befindet sich meist nur kurzzeitig zu bestimmten Zeitpunkten in kritischen Phasen. Die kritischen Phasen können durch die eigenen logischen Sequenzen, oder durch logische Sequenzen seiner Schaltungsumgebung herbeigeführt werden. Dadurch daß die Sequenzen vom betriebsmäßigen logischen Ablauf erzeugt werden, kann das Auftreten einer kritischen Phase sehr selten sein. Die Wahrscheinlichkeit, daß der Störimpuls des Störgenerators eine mit relativ geringer Wahrscheinlichkeit auftretende kritische Phase trifft und damit den IC prüft, ist relativ gering. Lange Prüfzeiten sind erforderlich, um einen akzeptablen statistischen Vertrauensbereich zu erhalten.

Ebenfalls ist auch unter Berücksichtigung der vorgenannten Zusammenhänge die Unterscheidbarkeit von Funktionsfehlern, die von anderen IC herrühren, nur schwer gegeben.

Aufgabe der Erfindung ist es deshalb, die für die Bewertung und den Vergleich von IC-EMV-Eigenschaften notwendigen, allgemeingültigen Kenngrößen einzuführen und technische Einrichtungen zu schaffen, mit denen diese Kenngrößen bzw. Parameter ermittelt werden können. Damit sollen dem Fachmann neben den üblichen IC-Kenngrößen die entsprechenden EMV-Parameter bereitgestellt werden.

Eine erfindungsgemäße Lösung dieser Aufgabe ist im Patentanspruch 1 und 13 gegeben. Weiterbildungen der Erfindung sind in den Unteransprüchen gekennzeichnet.

Nach Vorgabe der Erfindung setzen die IC-EMV-Kenngrößen an den Wirkungsmechanismen der IC-Beeinflussung an. Es sind 4 Meßaufgaben erkennbar, in denen
a) über die Beeinflussung von Grundgattern die Gatterempfindlichkeit,
b) über die Beeinflussung von IC-internen logischen Schaltungen die Strukturempfindlichkeit,
c) über die Beeinflussung von nachgeschalteten IC die Überkopplung,
d) über die Beeinflussung durch IC-externe Felder die Feldempfindlichkeit
gemessen werden kann.

Zum Erfassen dieser vier Eigenschaften lassen sich Beeinflussungsparameter ableiten und Meßschaltungen entwickeln.

Die Gatterempfindlichkeit ist eine fundamentale Kenngröße von IC. Andere EMV-Kenngrößen basieren auf dem Mechanismus, der der Gatterempfindlichkeit zugrunde liegt.

Die Gatterempfindlichkeit charakterisiert die Wandlung von Störgrößen in logische Signale. Die Störgröße, die am Eingang des Gatters anliegt, wird anstelle eines logischen Signals erfaßt und im Gatter in ein logisches Ausgangssignal gewandelt.

Das vermeintliche logische Signal wird dann fälschlicherweise von den nachfolgenden Schaltungen weiterverarbeitet.

Höher integrierte Schaltungen sind aus einzelnen Gattern aufgebaut. Dabei kann es sich um sequentielle Grundschaltungen oder für die Computertechnik charakteristische hochintegrierte Spezialschaltungen handeln. Der Beeinflussungsmechanismus der hochintegrierten IC basiert auch auf dem Prinzip der Gatterbeeinflussung bzw. der Gatterempfindlichkeit.

Die Gatterstörschwelle verläuft analog der statischen und dynamischen Schaltschwelle eines Gattereingangs. Für geringe Störimpulsbreiten sind zur Erreichung der Störschwelle analog der statischen und dynamischen Schaltschwelle höhere Scheitelwerte erforderlich. Die Gatter werden im Bereich der dynamischen Störschwelle für kurze Störimpulse unempfindlicher. Dem entgegen dringen aber besonders kurze Störimpulse über die Geräteschnittstellen und die geometrische Struktur des Gerätes und der Leiterkarten bis an die Gattereingänge vor. Deshalb liegt im übergangsgebiet der statischen zur dynamischen Störschwelle der empfindlichste Bereich für die Störfestigkeit. Die Lage dieses überganges (im Kennlinienverlauf) ist deshalb ein Maß für die Empfindlichkeit des IC gegenüber impulsförmigen Störgrößen.

Um die Gatterempfindlichkeit festzustellen, wird am Gattereingang eine Folge von Störimpulsen (Störspannung) definierter Form angelegt. Die Störimpuls-Parameter müssen einen Bereich der dynamischen und den Übergang zur statischen Störschwelle abdecken. Im Gatter wird bei Störschwellenüberschreitung der Störimpuls in ein logisches Signal gewandelt, welches am Gatterausgang von einer Impulsfalle aufgefangen wird. Die Impulsfalle dehnt das Signal und leitet es zur Auswertung weiter.

Der Prüfimpuls muß einen definierten Verlauf besitzen, der durch Parameter gekennzeichnet werden kann. Er kann z.B. die Form eines steil auf den Scheitelwert û ansteigenden und mit der Zeitkonstante τ vom Scheitelwert û fallenden Exponentialimpulses besitzen.

Bei IC mit komplizierter logischer Struktur kann die Messung der Gatterempfindlichkeit in der Weise erfolgen, daß ein Störgenerator über ein Koppelfeld an den entsprechenden Eingang des IC geschaltet ist und die Ein- bzw. Ausgänge des IC über einen Verteiler einer Ein-/Ausgabeeinheit, die zugleich die Funktion der Impulsfalle ausführt, zugeordnet sind.
Eine Impulssperre, die beispielsweise als Filter oder Induktivität ausführbar ist, gewährleistet die Entkopplung des Störgenerators von der Ein-/Ausgabeeinheit.

Die Verknüpfung der Funktionselemente Störgenerator, Koppelfeld, Verteiler sowie Ein-/Ausgabeeinheit zur Ausführung der Meßaufgabe am IC-Prüfling erfolgt durch eine Simulationseinheit mit Steuer- und Auswertefunktion.

Bei der Messung der Strukturempfindlichkeit ist von folgenden Zusammenhängen auszugehen.

Das logische System eines IC kann aus mehreren funktionellen Einheiten bestehen, die untereinander logisch verbunden sind. Im einfachsten Fall kann eine funktionelle Einheit ein Gatter sein, welches mit einer zweiten funktionellen Einheit, d.h. einem zweitem Gatter, verbunden ist. Die funktionellen Einheiten können aber auch eine komplizierte Struktur besitzen und logische Sequenzen erzeugen, austauschen und verarbeiten (z.B. ALU, Registersätze, PROM, Ports, ADU). Auch kann die Funktion des logischen Systems eines IC von logischen Sequenzen anderer IC abhängig sein.

Zur Durchführung des Meßvorganges wird ein impulsförmiger Störstrom in einem Generator erzeugt und in die Ein- und Ausgänge des IC eingespeist. Dabei können alle oder nur bestimmte Ein- bzw. Ausgänge für die Störstromeinspeisung benutzt werden. Der Störstrom fließt über die inneren Strukturen des IC hauptsächlich über den Masse- und Versorgungsspannungsanschluß (GND, V_{cc}) nach außen ab.

Nicht durch die Störgröße beaufschlagte Ein-/Ausgänge können über logische Elemente mit definierten EMV-Eigenschaften abgeschlossen oder durch eine Impulssperre getrennt werden.

Logische Verbindungen, die die funktionellen Einheiten verknüpfen, können ausgelöst von einem Störimpuls z.B. über induktive Kopplung L, ohmsche Kopplung R und magnetische Kopplung M beeinflußt werden. Von dem im IC fließenden Störstrom werden durch diese Kopplungen Störspannungen erzeugt. Diese werden von Signalleitungen, die an die Eingänge der funktionellen Einheiten führen, abgegriffen und überlagern sich den logischen Sequenzen (Gatterbeeinflussungen). Wenn kritische Phasen getroffen werden, können logische Zustände oder Sequenzen der funktionellen Einheit verändert werden.

Durch die Simulationseinheit wird die betriebsmäßig notwendige Sequenz und die Sequenz, die die Funktionsfehler nach außen überträgt, erzeugt. Bei Beeinflussung des IC durch den Störimpuls enthält die vom IC abgegebene Sequenz Fehler, die von der in der Simulationseinheit integrierten Überwachungseinrichtung erkannt werden.
Am Generator wird die Störgröße so weit erhöht, bis Fehler in der Sequenz auftreten. Die Parameter des zugehörigen Störimpulses oder die Generatorparameter können als EMV-Kennwert für die Strukturempfindlichkeit verwendet werden. Als Störimpuls kann auch ein Stromimpuls verwendet werden. Parameter können z.B. die Anstiegszeit, Rückenzeit und der Scheitelwert des Stromimpulses sein. Dabei können die Anstiegszeit und die Rückenzeit feste Parameter sein, und der Stromscheitelwert kann als EMV-Kennwert verwendet werden.

Die Strukturempfindlichkeit kann für bestimmte logische Funktionseinheiten des IC und ihre speziellen Betriebsweisen ermittelt werden. Dafür ist jeweils eine bestimmte Simulationssequenz erforderlich. Es müssen die entsprechenden Gebiete im IC aktiviert und von der Auswerteeinheit kontrollierbar gemacht werden. Dabei kann eine statistische Auswertung erforderlich sein, weil bei IC mit komplizierten Strukturen nur für kleine Zeitabschnitte kritische Phasen auftreten und deshalb nur selten vom Störimpuls getroffen werden. Zur Erhöhung der Trefferwahrscheinlichkeit ist eine Koordinierung der Störimpulsauslösung mit der Sequenzfolge möglich. Es kann ein Regelungsbzw. Lerneffekt benutzt werden. In Meßdurchläufen können die kritischen Phasen analysiert und dann gezielt benutzt werden. Dafür muß der Störgenerator mit dem Simulationssystem synchronisiert werden. Im einfachsten Fall kann das durch Einhalten einer bestimmten Phasendifferenz zwischen Störimpulsauslösung und Sequenzperiode realisiert werden.

Für die Messung der Überkopplung gilt der folgende Ausgangspunkt. Der Störstrom, der über Ein- bzw. Ausgänge in den IC einfließt, kann die Verbindungen zu anderen IC im Potential kurzzeitig durch IC-interne Massepotential-(GND)-Spannungsabfälle anheben. Nachgeschalteten IC wird ein Eingangssignal vorgetäuscht. Es muß eine Kenngröße definiert werden, die dieses Verhalten beschreibt. Außerdem muß ein Meßverfahren geschaffen werden, mit dem diese Kennwerte ermittelt werden können.

Bei der Realisierung des Meßverfahrens ist eine Kopplung über die Ausgänge oder über die Eingänge bzw. über die im Tristate Zustand befindlichen Ausgänge möglich.

Bei der Kopplung über die Ausgänge werden bis auf den zu überwachenden Ausgang alle Ausgänge und alle Eingänge oder nur spezielle Ein- und Ausgänge an den Störgenerator geschaltet (analog zur Messung der Strukturempfindlichkeit).

Der Störimpuls erzeugt GND-Anhebungen, die mit einem Referenzeingang RE von einem Ausgang abgegriffen werden. Der Referenzeingang hat eine definierte Gatterempfindlichkeit und einen definierten Eingangswiderstand. Die GND-Anhebungen wandelt der Referenzeingang RE bei überschreiten der dynamischen Störschwelle in logische Signale. Diese Signale werden von einer Impulsfalle aufgefangen, gedehnt und einer Auswerteeinrichtung zugeführt. Im Meßablauf wird der Scheitelwert des Stromimpulses so weit gesteigert, bis die Impulsfalle ein Signal auffängt. Die zugehörigen Parameter des Stromimpulses bzw. des Generators können als Parameter und Kennwerte der Überkopplung verwendet werden.
Durch Sequenzen einer Simulationseinheit kann der Ausgang in definierte logische Zustände gebracht werden.

Eine weitere Variante der Überkopplung, nämlich die Kopplung über die Eingänge entsteht dann, wenn der Störstrom wie oben erläutert in den IC einfließt jedoch ein Teil über einen Eingang ausfließt und an einem nachgeschalteten Ausgang (RA) einen Störspannungsabfall erzeugt. Wenn an diese Anordnung ein weiterer Eingang (RE) geschaltet wird, kann dieser durch den Spannungsabfall beeinflußt werden.

Am Ausgangswiderstand des Referenzausganges RA wird durch den Teilstörstrom eine Störspannung U erzeugt, die auch am Referenzeingang RE anliegt. Der Referenzeingang RE wandelt bei Überschreiten der dynamischen Störschwelle die Störspannung in ein Störsignal, welches von der Impulsfalle aufgefangen wird. Im Meßablauf wird der Scheitelwert des Stromimpulses so weit gesteigert, bis die Impulsfalle ein Signal auffängt. Die zugehörigen Parameter des Stromimpulses bzw. des Generators können als Parameter und Kennwerte der überkopplung verwendet werden.

Durch den Referenzausgang kann ein logischer Pegel vorgegeben werden.

Das Verfahren und die Meßanordnung kann gleichermaßen zur Bewertung von Ausgängen benutzt werden, die sich im Tristate Zustand befinden. Anstelle über den Eingang fließt dann der Störstrom aus dem im Tristate Zustand befindlichen Ausgang.-

Wird das magnetische Feld für die Ermittlung der Feldempfindlichkeit zugrunde gelegt, ist die Erzeugung eines pulsförmigen Magnetfeldes im IC-Bereich erforderlich. Die Ermittlung der Magnetfeldempfindlichkeit wird dadurch realisiert, daß über den Chip des IC eine Induktionsspule angebracht wird, durch die ein pulsförmiger Störstrom fließt. Der Störstrom erzeugt ein pulsförmiges Magnetfeld, welches in den Leiterschleifen des Chips Störspannungen induziert und die Schaltungen des Chips beeinflußt. Die Beeinflussung erfolgt analog den Mechanismen, die bei der Messung der Strukturempfindlichkeit beschrieben wurden. Sie wird an fehlerhaften logischen Signalen und Inhalten erkannt. Dabei kann die äußere logische Umgebung des IC mit einer Simulationseinheit nachgebildet werden. Wenn es sich um einen sequentiell arbeitenden IC handelt, können die kritischen Phasen des IC gezielt beeinflußt werden. In Meßdurchläufen können die kritischen Phasen identifiziert und dann gezielt benutzt werden. Dafür muß der Störgenerator mit dem Simulationssystem synchronisiert werden.

Wird das elektrische Feld als Koppelgröße für die Ermittlung der Feldempfindlichkeit zugrunde gelegt, so wird die Meßanordnung in der Weise modifiziert, daß über den Chip des IC eine Metallplatte im definierten Abstand angebracht ist. Die Platte und der Chip bzw. eine Gegenplatte werden mit einem Störgenerator verbunden und mit pulsförmiger Störspannung beaufschlagt. Durch elektrische Kopplung kann der Chip beeinflußt werden. Die Steuerung und Auswertung kann wie bei der Beeinflussung durch Magnetfelder erfolgen, nur daß an Stelle des Stromes eine Spannung verwendet wird.

Zur weiteren Erläuterung der Erfindung wird auf die Patentansprüche verwiesen.
Einzelheiten, Merkmale und Vorteile der Erfindung ergeben sich auch aus der nachfolgenden Beschreibung von Ausführungsbeispielen. In der zugehörigen Zeichnung zeigen
- Fig. 1: einen Prüfimpuls mit definiertem Verlauf zur Messung der Gatterempfindlichkeit,
- Fig. 2: zwei Meßstrategien zum Ablauf der Messung der Gatterempfindlichkeit,
- Fig. 3: eine prinzipielle Schaltungsanordnung zur Erzeugung der Burstimpulse und zur Messung der Gatterempfindlichkeit,
- Fig. 4: eine Meßanordnung zur Messung der Gatterempfindlichkeit für IC mit komplizierter logischer Struktur,
- Fig. 5: eine Meßanordnung zur Bestimmung der Strukturempfindlichkeit,
- Fig. 6: die Prinzipschaltung eines Störgenerators für die Stromimpulserzeugung,
- Fig. 7: zwei Meßanordnungen zur Bestimmung der überkopplung,
- Fig. 8: zwei Meßanordnungen zur Ermittlung der Feldempfindlichkeit,
- Fig. 9: eine Meßanordnung zur Ermittlung der E-Feldempfindlichkeit.

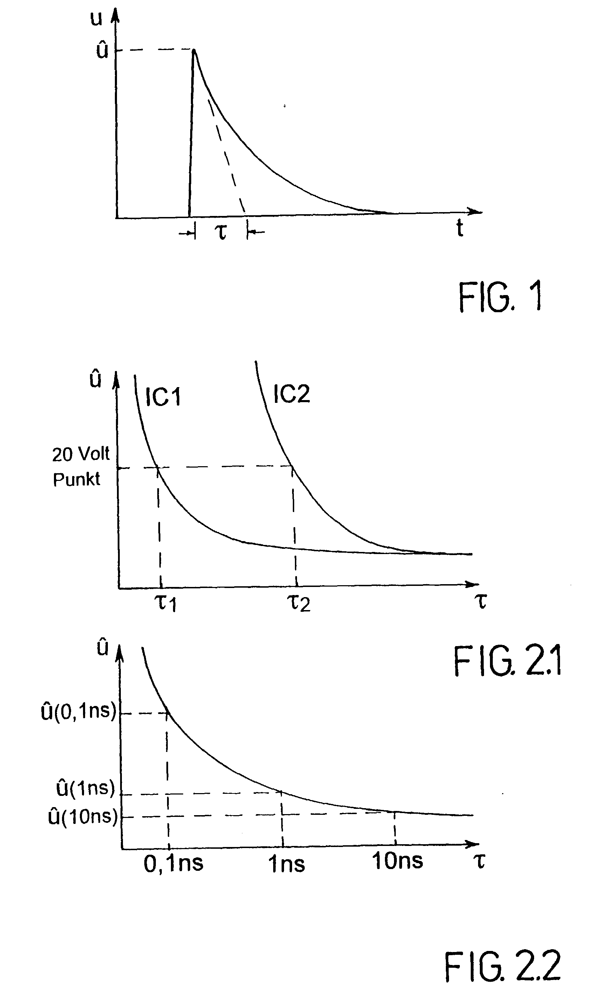

Die Figuren 1 bis 4 dienen zur Beschreibung von Realisierungsbeispielen für Meßverfahren und Meßvorrichtungen zur Ermittlung der Gatterempfindlichkeit.

Mit Exponentialimpulsen nach Fig. 1 wird die dynamische Stör-/Schaltschwelle ermittelt. Für den Kennwert der Gatterempfindlichkeit wird die Lage des überganges zur dynamischen Störschwelle verwendet. Der Übergang wird durch markante Punkte bestimmt. Derartige Punkte stellen Kennwerte (Parameter) der Gatterempfindlichkeit dar.

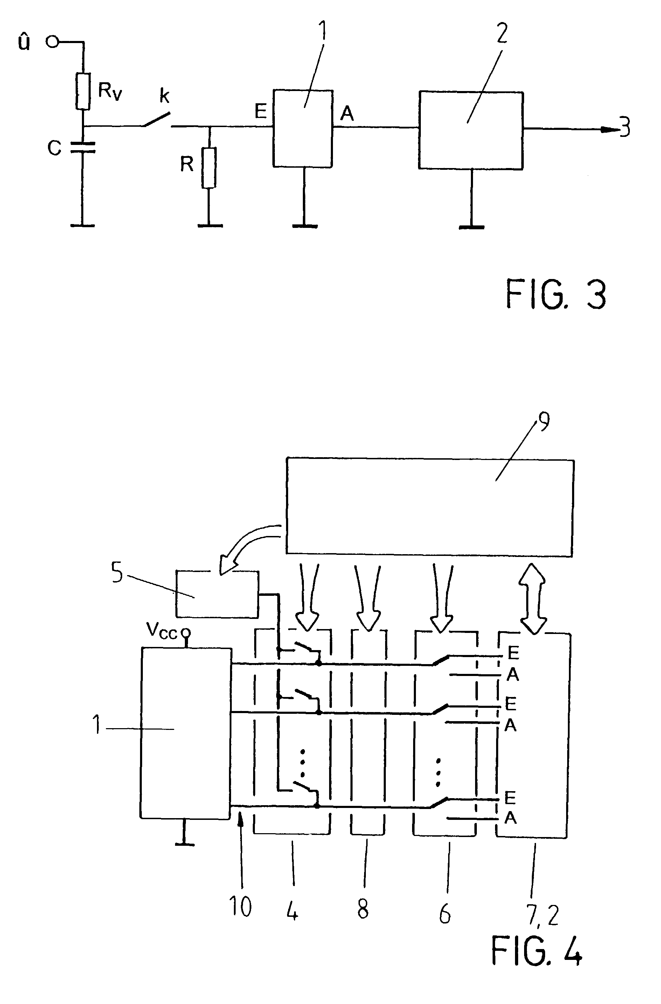

Zum Ablauf des Verfahrens wird einmal für einen festgelegten Spannungswert die Impulsbreite (Zeitkonstantenwert τ) als Parameter bestimmt. In Fig. 2.1 ist als Spannungswert der 20 Volt Wert festgelegt. Der zugehörige Wert der Zeitkonstante τ (20 Volt) des Störimpulses wird wie beschrieben durch schrittweises Verändern von τ meßtechnisch ermittelt. Es kann so vorgegangen werden, daß bei einem Scheitelwert û von 20 Volt die Zeitkonstante so weit erhöht wird, bis die dynamische Störschwelle erreicht ist. Ebenso kann der Zeitkonstantenwert τ (20 Volt) aus der meßtechnisch ermittelten Kennlinie der dynamischen Schaltschwelle entnommen werden.
In Fig. 2.1 ist auf diese Weise die dynamische Störschwelle für IC 1 bei τ₁ und IC 2 bei τ₂ erreicht.

Aufbauend auf dieser Vorgehensweise kann eine festgelegte Impulsfolge mit konstanter Impulszahl aber definiert veränderlichen Parametern (τ, û) verwendet werden. Aus der Zahl der Störschwellenüberschreitungen ist dann der Empfindlichkeitswert errechenbar.

Zum anderen werden zur Durchführung des Meßverfahrens für bestimmte Zeitkonstantenwerte die zugehörigen Spannungswerte û als Parameter bestimmt. In Fig. 2.2 werden die Zeitkonstantenwerte τ = 0,1; 1; 10 Nanosekunden verwendet. Aus der gemessenen dynamischen Störschwelle oder den punktuellen Messungen bei den entsprechenden Zeitkonstantenwerten, wird der Scheitelwert
û (0,1ns)
û (1ns)
û (10ns)
der zugehörigen Störspannung ermittelt.

Zur Erzeugung der Burstimpulse und der zu erfassenden Beeinflussung kann die Schaltung nach Fig. 3 verwendet werden.
Es wird eine bestimmte Spannungshöhe û eingestellt. über den Widerstand Rᵥ wird der Kondensator C auf die Spannung û aufgeladen. Beim Schließen des Kontaktes K wird der Kondensator C über den Widerstand entladen. Am IC-Eingang E (Gattereingang) entsteht ein steil ansteigender und exponentiell abfallender Spannungsimpuls. Beim Überschreiten der Störschwelle des Eingangs E erzeugt das zugehörige Gatter 1 ein logisches Signal L, welches von der Impulsfalle 2 aufgefangen und einer Auswertug 3 zugeführt wird. Durch Variation von R und C läßt sich die Zeitkonstante T verändern. Es können der Verlauf der dynamischen Störschwelle oder die Parameter direkt gemessen werden.

Dem Gattereingang kann ein Einkoppel- und ein Entkoppelnetzwerk vorgeschaltet werden, um die Untersuchungen bei beliebigen logischen Pegeln ausführen zu können.

Eine Meßanordnung für IC mit komplizierter logischer Struktur zeigt Fig. 4.

Über ein Koppelfeld 4 wird der Störgenerator 5 an den entsprechenden Eingang des IC (Prüfling) geschaltet. Über einen Verteiler 6 werden Ein- bzw. Ausgänge einer Ein-/Ausgabeeinheit 7 zugeordnet. In diese Ein-/Ausgabeeinheit ist auch die Funktion der Impulsfalle integriert. Durch eine Impulssperre 8 (Filter, Drossel) kann der Störgenerator 5 von der Ein-/Ausgabeeinheit 7 entkoppelt werden. Im Koppelnetzwerk können Elemente zur gleichstrommäßigen Entkopplung des Störgenerators 5 enthalten sein.

An den IC werden von einer Simulationseinheit 9 mit Steuerund Auswertefunktion über die Ausgabeeinheit 7 bestimmte logische Pegel oder Sequenzen ausgegeben, um den IC auf die Beeinflussung vorzubereiten. Wenn der Ausgang eines IC-Gatters 1 über bereits freie Wege an einen Ausgang des IC führt, genügt es, einen bestimmten IC-Eingangspegel durch eine Ausgabe der Ausgabeeinheit aufzuschalten. Wenn kein Weg frei ist, kann, wenn im IC ein freischaltbarer Weg existiert, durch bestimmte IC-Eingangsbelegungen oder IC-Eingangssequenzen ein Weg freigeschaltet werden. Wenn ein freischaltbarer Weg nicht existiert, können, wenn vorhanden, IC-interne logische Strukturen zum Auffangen und Speichern des Gatterstörsignals benutzt werden. Für diesen Zweck müssen die logischen Strukturen in einen entsprechenden Zustand oder in einen entsprechenden zyklischen Ablauf gebracht werden. Das kann durch Sequenzen erfolgen, die von der Ausgabeeinheit abgegeben werden. Dieser Prozeß kann über die IC-Ein- bzw. Ausgänge 10 von der Simulationseinheit 9 verfolgt werden.

Die Simulations-/Steuereinheit 9 schaltet einen Störimpuls auf den gewünschten Eingang 10. Die dadurch u.U. erzeugte innere logische Veränderung (Gatterstörsignal) wird, wenn sie direkt an einen Ausgang gelangt, mit einer Impulsfalle 2 aufgefangen. Wenn die logische Veränderung in der logischen Struktur des IC gespeichert wurde, wird durch Anlegen von Sequenzen an die Eingänge eine entsprechende Information an die Ausgänge durchgeschaltet und der Auswertung zugeführt. Ebenso kann ein durch die Beeinflussung erzeugter fehlerhafter Ablauf einer seriellen Sequenz überwacht werden. Das Fehlerereignis tritt ab einer bestimmten Störschwelle, der dynamischen Störschwelle, ein. Die EMV-Parameter können ebenfalls punktuell oder aus einer aufgenommenen Kennlinie ermittelt werden. Die Ermittlung kann in der Auswerteeinrichtung erfolgen.

Das Verfahren kann abgerüstet werden, so daß z.B. nur ein bestimmter IC-Typ über eine feste logische Verschaltung benutzt werden kann. Das Koppelfeld 4 und das Verteilerfeld 6 sind dann nicht erforderlich. Bei entsprechend unkomplizierten IC kann dann auch auf die Erzeugung logischer Sequenzen verzichtet werden. Die Messung kann auch von Hand ohne halb- oder vollautomatische Auswerteinrichtung ausgeführt werden.

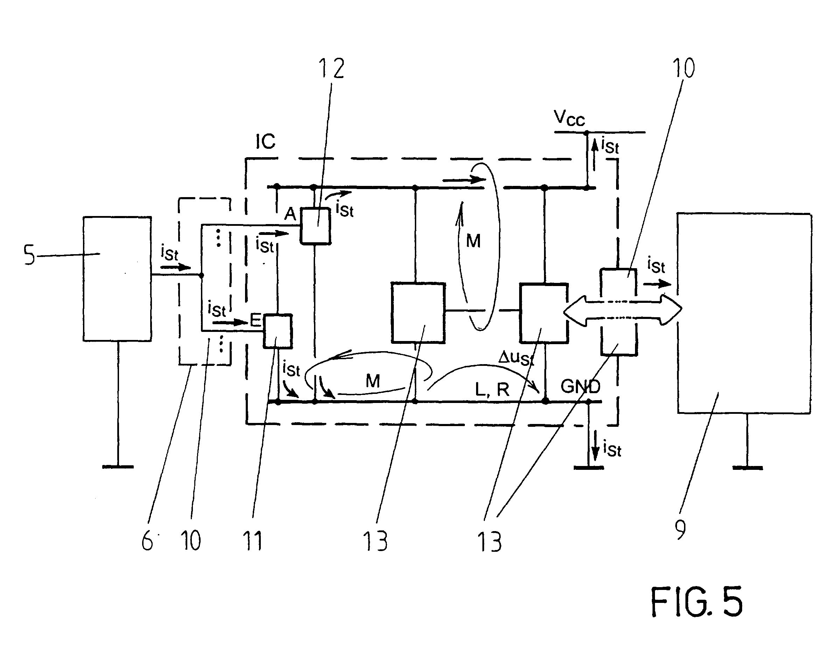

Die Meßanordnung nach Fig. 4 kann auch für die Ermittlung der Strukturempfindlichkeit eingesetzt werden.
Bei der Meßanordnung nach Fig. 5 zur Bestimmung der Strukturempfindlichkeit wird ein vom Störgenerator 5 erzeugter impulsförmiger Störstrom iₛₜ über einen Verteiler 6 in die Ein- und Ausgänge 10 bzw. Eingangsschaltungen 11 und Ausgangsschaltungen 12 des IC eingespeist.
Der Störstrom fließt über die inneren Strukturen und funktionellen Einheiten 13 des IC insbesondere über den Masse- und Versorgungsspannungsanschluß (GND, Vcc) nach außen ab. Ein Abfließen kann jedoch auch über die nicht mit dem Störgenerator verbundenen Ein-/Ausgänge erfolgen. Der Abschluß dieser Ein-/Ausgänge kann mit einer definierten Last, beispielsweise einem bestimmten Gatter, durchgeführt werden.
Durch die Simulationseinheit 9 mit Steuer- und Auswertefunktion werden die zur Messung erforderlichen Betriebsund Fehlerzustände eingestellt, erfaßt und ausgewertet.

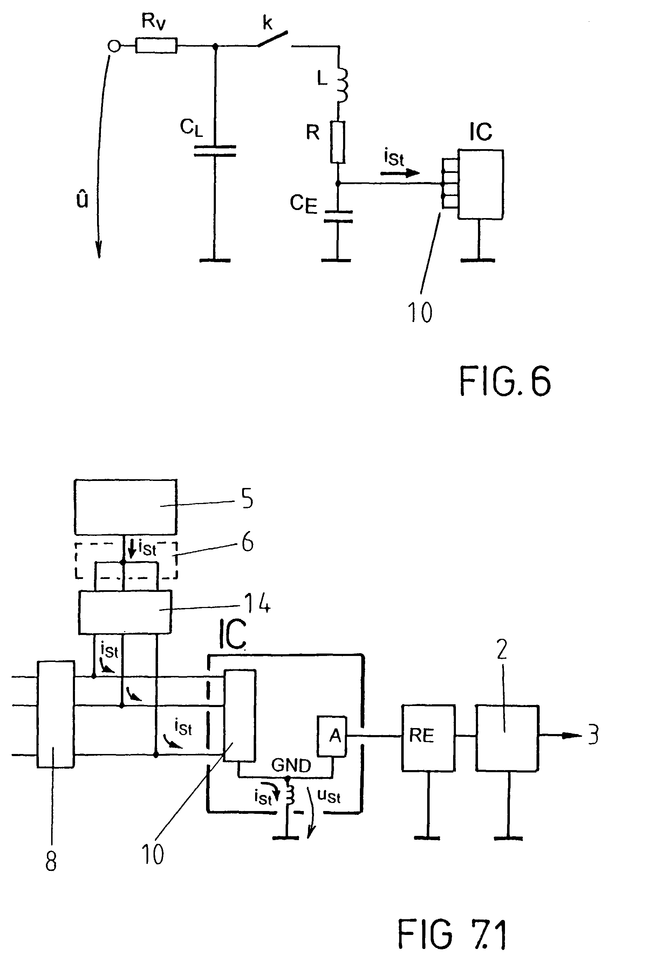

Einen Generator für die Störimpulserzeugung zeigt Fig. 6. Der Kondensator C_{L} wird über den Widerstand Rv auf die einstellbare Spannung û aufgeladen. Beim Schließen entlädt der Kontakt K den Kondensator C_{L} über den Widerstand R und die Induktivität L in den IC-Prüfling. Die Elemente L und CE bewirken eine definierte Anstiegszeit für den Stromimpuls. Die Schaltung erzeugt ebenfalls eine konstante Rückenzeit. Feste Parameter für eine Messung könnten die Anstiegszeit und die Rückenzeit sein. Der Kennwert der Strukturbeeinflussunggröße ist dann der Scheitelwert des Stromes oder die Ladespannung des Kondensators C_{L}.

Mit einer Strommeßeinrichtung können die Parameter des Stromimpulses gemessen werden. Durch einen Vergleich mit einem Sollwert können die Generatorparameter so verstellt werden, daß der gewünschte Stromverlauf entsteht.

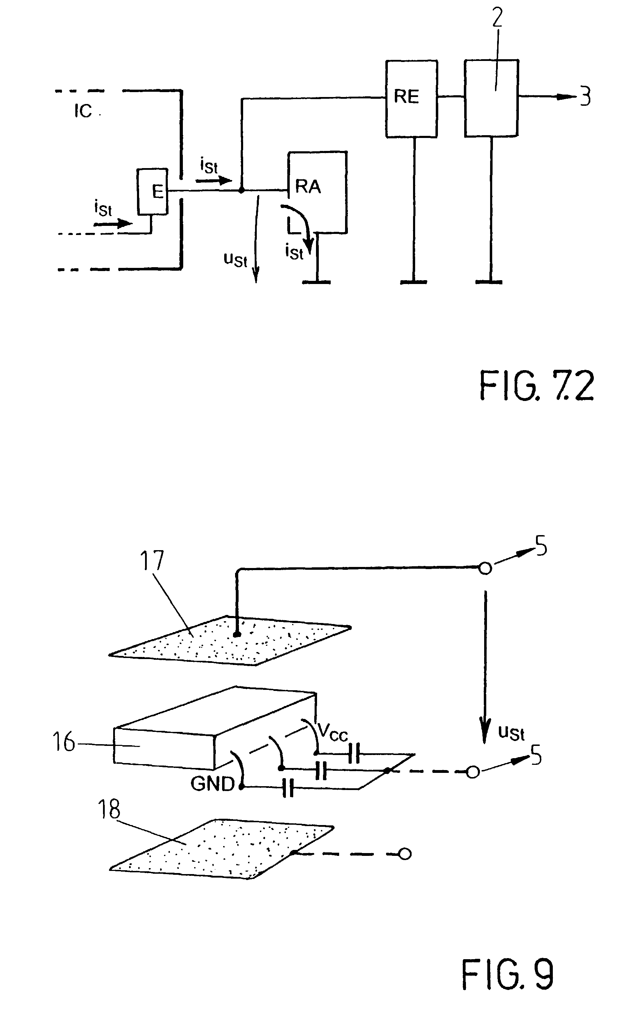

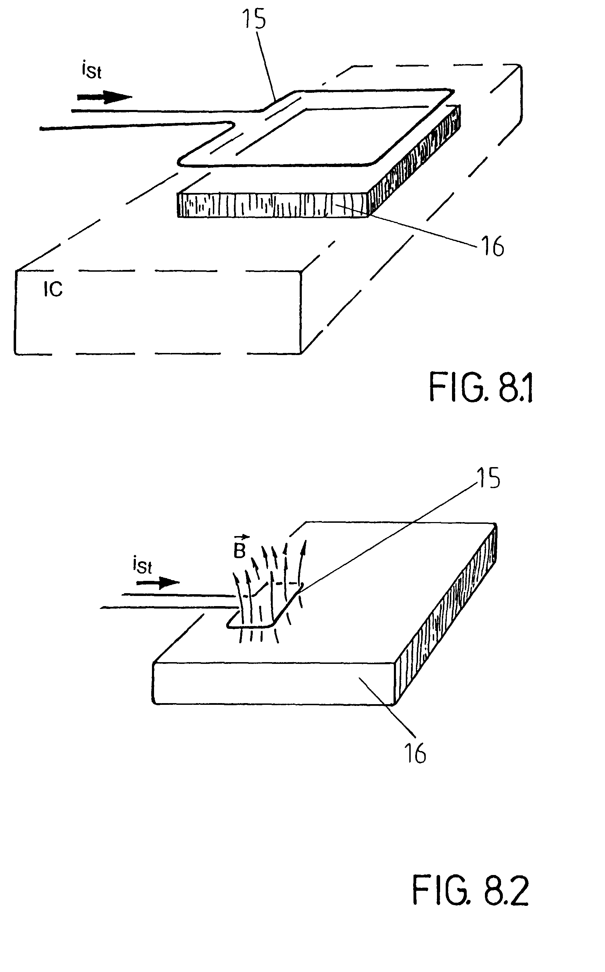

Die Prinzipschaltungen für zwei Meßanordnungen zur Ermittlung der überkopplung zeigt Fig. 7; in Fig. 7.1 erfolgt dabei die Kopplung über die Ausgänge und in Fig. 7.2 über die Eingänge bzw. über Ausgänge im Tristate Zustand. Bei Fig. 7.1, also bei der Kopplung über die Ausgänge, wird der Störstrom iₛₜ vom Störgenerator 5 über einen Verteiler 6 und einer Einrichtung 14 zur Gleichstrom-Signal-Entkopplung den Ein- bzw. Ausgängen 10 des IC zugeführt. Parallel dazu erfolgt eine definierte Belegung der IC-Eingänge 10 über eine Impulssperre 8 zur Entkopplung des Störstromimpulses von der Eingangsbelegung.

Der Störstrom iₛₜ erzeugt Massepotential-(GND)-Anhebungen, die mit dem Referenzeingang RE von dem Ausgang A abgegriffen werden. Beim Überschreiten der dynamischen Störschwelle ausgelöste logische Signale werden von der Impulsfalle 2 aufgefangen und einer Auswertung 3 zugeführt.

Fig. 7.2 veranschaulicht die Kopplung über die Eingänge bzw. im Tristatezustand befindliche Ausgänge.
Der nicht dargestellte, sich links anschließende Teil der Schaltung ist analog zu Fig. 7.1 aufgebaut.
Bei dieser Meßanordnung fließt der Störstrom iₛₜ zu einem Teil über einen Eingang E aus und erzeugt an dem nachgeordneten Ausgang RA einen Störspannungsabfall Uₛₜ. Ein parallel zum Referenzausgang RA geschalteter Referenzeingang RE wandelt bei überschreiten der dynamischen Störschwelle die Störspannung Uₛₜ in ein Störsignal, das von der Impulsfalle 2 aufgefangen und nachfolgend ausgewertet wird.

Als Störgenerator 5 kann der für die Messung der Strukturempfindlichkeit eingesetzte Generator Verwendung finden. In analoger Weise kann mit den hier benutzten Parametern und Kennwerten verfahren werden.
Für komplizierte IC-Strukturen kann die Anordnung nach Fig. 4 modifiziert werden.

Fig. 8 veranschaulicht zwei Meßanordnungen zur Ermittlung der Magnetfeldempfindlichkeit.
Dabei wird über dem Chip 16 des IC eine Induktionschleife 15 plaziert, durch die ein pulsförmiger Strom iₛₜ fließt. Durch die Magnetfeldkopplung werden in den Leiterschleifen des Chips 16 Störspannungen induziert, die zu auswertbaren fehlerhaften logischen Signalen führen.

Der Störstrom zur Speisung der Induktionsspule kann in dem für die Messung der Strukturempfindlichkeit eingesetzten Generator erzeugt werden. Parameter und Kennwerte der Feldbeeinflußbarkeit des IC können aus dem das Magnetfeld erzeugenden Störstrom oder aus den Parametern und Einstellwerten des Störgenerators gewonnen werden.

Mit einer Induktionsschleife entsprechender Kleinheit nach Fig. 8.2 können Chipbereiche selektiv untersucht werden. Gebiete mit hoher Empfindlichkeit können auf diese Weise ermittelt werden.

Bild 9 zeigt eine Meßanordnung zur Ermittlung der E-Feldempfindlichkeit. Dabei wird an den Chip 16 über kapazitive Kopplung ein Störgenerator 5 angeschlossen; der andere Pol des Störgenerators wird an eine Koppelplatte 17 gelegt, die einen definierten Abstand vom Chip 16 besitzt.
Anstelle einer kapazitiven Kopplung kann der Störgenerator auch an eine unter dem Chip befindliche Gegenplatte 18 angeschlossen werden. Im weiteren wird wie bei der Magnetfeldbeeinflussung verfahren.

## Patentansprüche

1. Verfahren zur Bewertung der passiven EMV-Eigenschaften von integrierten Schaltungen durch ihre Beaufschlagung mit Prüfimpulsen, die von einem Störgenerator (5) erzeugt werden,
**dadurch gekennzeichnet,** daß die auszuwertenden EMV-IC-Parameter an den Wirkungsmechanismen der IC-Beeinflussung ansetzen und damit
a) über die Beeinflussung von Grundgattern die Gatterempfindlichkeit,
b) über die Beeinflussung von IC-internen logischen Schaltungen die Strukturempfindlichkeit,
c) über die Beeinflussung von nachgeschalteten IC die überkopplung und
d) über die Beeinflussung durch IC-externe Felder die Feldempfindlichkeit
gemessen wird.

2. Verfahren nach Anspruch 1,
**dadurch gekennzeichnet,** daß die Gatterempfindlichkeit durch die Bestimmung des für die Störfestigkeit sensiblen Übergangsgebietes der statischen zur dynamischen Störschwelle, der Lage dieses übergangs im Kennlinienverlauf ermittelt wird, wozu am Gattereingang E eine Folge von Störimpulsen als Störspannung definierter Form angelegt wird, deren Parameter einen Bereich der dynamischen und den Übergang zur statischen Störschwelle abdecken und im Gatter (1) der Störimpuls bei Störschwellenüberschreitung in ein logisches Signal gewandelt wird, das am Gatterausgang (A) von einer Impulsfalle (2) aufgefangen wird, wobei durch die Impulsfalle das Signal gedehnt und zur Auswertung (3) weitergeleitet wird,
und daß der einzelne Stör- bzw. Prüfimpuls die Form eines steil auf den Scheitelwert û ansteigenden und mit der Zeitkonstante T vom Scheitelwert û abfallenden Exponentialimpulses aufweist.

3. Verfahren nach Anspruch 1,
**dadurch gekennzeichnet,** daß zur Messung der Strukturempfindlichkeit der von einem Störgenerator erzeugte impulsförmige Störstrom in die Ein- und/oder Ausgänge 10 des IC eingespeist wird, wobei alle oder nur bestimmte Ein- bzw. Ausgänge benutzbar sind und vom über die inneren Strukturen des IC hauptsächlich über den Masse- und
Versorgungsspannungsanschluß nach außen abfließenden Störstrom über induktive, ohmsche und magnetische Kopplungen Störspannungen erzeugt werden, die bei Erreichung kritischer Phasen zur Veränderung logischer Zustände oder Sequenzen der jeweiligen funktionellen Einheit (13) führen können, was von einer Simulationseinheit (9) mit Steuer- und Auswertefunktion registriert, beeinflußt und aufgezeichnet wird.

4. Verfahren nach Anspruch 3,
**dadurch gekennzeichnet**, daß nicht durch die Störgröße beaufschlagte Ein-/Ausgänge über logische Elemente mit definierten EMV-Eigenschaften abgeschlossen oder durch eine Impulssperre getrennt werden.

5. Verfahren nach Anspruch 3 oder 4,
**dadurch gekennzeichnet,** daß durch die Simulationenseinheit (9) die betriebsmäßig notwendige Sequenz und die Sequenz, die die Funktionsfehler nach außen überträgt, erzeugt wird und dabei am Generator (5) die Störgröße so weit erhöht wird, bis Fehler in der Sequenz auftreten.

6. Verfahren nach einem der Ansprüche 3 oder 5,
**dadurch gekennzeichnet,** daß die Ermittlung der Strukturempfindlichkeit für bestimmte logische Funktionseinheiten des IC und ihre speziellen Betriebsweisen durch Vorgabe einer definierten Simulations sequenz erfolgt,
und daß zur Erhöhung der Meßsicherheit eine Koordinierung der Störimpulsauslösung mit der Sequenzfolge durchgeführt werden kann, wobei ein Regelungs- bzw. Lerneffekt für die Analyse und gezielte Nutzung kritischer Phasen der Meßdurchläufe anwendbar ist und der Störgenerator (5) mit dem Simulationssystem (9) synchronisiert wird.

7. Verfahren nach Anspruch 1,
**dadurch gekennzeichnet,** daß zur Messung der überkopplung bis auf den zu überwachenden Ausgang (A) alle Ausgänge und alle Eingänge (10) oder nur spezielle Ein- und Ausgänge an den Störgenerator (5) angeschlossen werden und der Störstrom Massepotential-Anhebungen erzeugt, die mit einem Referenzeingang (RE) vom Ausgang (A) abgegriffen werden, wobei der Referenzeingang (RE) eine definierte Gatterempfindlichkeit und einen definierten Eingangswiderstand besitzt, und die Massepotential-Anhebungen vom Referenzeingang (RE) bei überschreiten der dynamischen Störschwelle in logische Signale umgewandelt werden und nachfolgend diese Signale von einer Impulsfalle (2) aufgefangen, gedehnt und einer Auswerteeinrichtung (3) zugeführt werden.

8. Verfahren nach Anspruch 1 und 7,
**dadurch gekennzeichnet,** daß der Störstrom in den IC einfließt, jedoch ein Teil über einen Eingang (E) an einem nachgeschalteten Referenzausgang (RA) einen Störspannungsabfall erzeugt und parallel zum Referenzausgang (RA) ein weiterer Eingang (RE) geschaltet wird, an dem auch die Störspannung anliegt, so daß bei überschreiten der dynamischen Störschwelle der Referenzeingang (RE) die Störspannung in eine Störsignal wandelt, das von der Impulsfalle (2) aufgenommen wird.

9. Verfahren nach Anspruch 8,
**dadurch gekennzeichnet,** daß durch den Referenzausgang (RA) ein logischer Pegel vorgegeben wird.

10. Verfahren nach Anspruch 7 oder 8,
**dadurch gekennzeichnet**, daß eine Kopplung über die Ausgänge oder über die Eingänge oder über die im Tristatezustand befindlichen Ausgänge erfolgt.

11. Verfahren nach Anspruch 1,
**dadurch gekennzeichnet,** daß zur Ermittlung der Feldempfindlichkeit auf der Grundlage von Pulsmagnetfeldern über dem Chip (16) des IC eine Induktionsspule (15) oder Induktionsschleife angeordnet wird, die mit einem pulsförmigen Störstrom beaufschlagt ist, wodurch in den
Leiterschleifen des Chips (16) Störspannungen induziert und die Schaltungen des Chips beeinflußt werden, wobei zur Ermittlung von Chipbereichen hoher Empfindlichkeit entsprechend kleine Induktionsschleifen eingesetzt werden können.

12. Verfahren nach Anspruch 1, 5 oder 6,
**dadurch gekennzeichnet**, daß die äußere logische Umgebung des IC mit einer Simulationseinheit (9) nachgebildet wird.

13. Anordnung zur Durchführung des Verfahrens nach Anspruch 1 oder 2,
**dadurch gekennzeichnet,** daß zur Messung der Gatterempfindlichkeit für IC mit komplizierter logischer Struktur ein Störgenerator (5) über ein Koppelfeld (4) an den entsprechenden Eingang (10) des IC geschaltet ist und über einen Verteiler (6) die Ein- bzw. Ausgänge (10) des IC einer Ein-/Ausgabeeinheit (7), die zugleich die Funktion der Impulsfalle (2) ausführt, zugeordnet sind, wobei durch eine Impulssperre (8), die als Filter oder Induktivität ausführbar ist, der Störgenerator (5) von der Ein-/Ausgabeeinheit (7) entkoppelt ist und die Funktionselemente Störgenerator (5), Koppelfeld (4), Verteiler (6) und Ein-/Ausgabeeinheit (7) mit einer Simulationseinheit (9) mit Steuer- und Auswertefunktion verknüpft sind.

14. Anordnung nach Anspruch 13,
**dadurch gekennzeichnet,** daß nur ein bestimmter IC-Typ über eine feste logische Verschaltung einsetzbar ist und in diesem Fall das Koppelfeld (4) und der Verteiler (6) nicht erforderlich sind.

## Claims

1. Procedure for the evaluation of the passive EMC properties of integrated circuits by application of test pulses that are produced by an interference generator (5) **characterized in** that the IC's EMC parameter to be tested are based on the mechanisms of the interference of the IC such that
a) the gate susceptibility is measured through the interference of basic gates;
b) the structural susceptibility is measured through the interference of IC-internal logical circuits;
c) the overcoupling is measured through the interference of ICs connected on output side;
d) the field susceptibility is measured through the interference by IC-external fields.

2. Procedure to Claim 1
**characterized in** that the gate susceptibility is evaluated through the determination of the transition region that is sensitive to interference immunity properties, from the static to the dynamic interference threshold, of the location of this transition on the characteristic curve for which at the gate input E, a sequence of interference pulses as an interference voltage of a defined shape is applied whose parameters cover a region of the dynamic and the transition to the static interference threshold, and in case of exceeded interference threshold, the interference pulse is transformed in the gate (I) into a logical signal which is captured at the gate output (A) by a pulse trap (2) whereby the signal is stretched by the pulse trap and passed to the evaluation device (3).

3. Procedure to Claim 1
**characterized in that** for the measurement of the structural susceptibility, the pulse-shaped interference current that is produced by an interference generator is fed into the inputs and/or outputs (10) of the IC whereby all, or only specific inputs, or outputs, respectively, can be used and interference voltages are produced by the interference current which flows off via the internal structures of the IC mainly through the earth and power supply connection to the outside, due to inductive, resistive and magnetic couplings, which interference voltages can, on reaching critical periods, lead to changes of logical states or sequences of the appropriate functional unit (13), which is sensed, influenced and recorded by a simulation unit (9) with control and evaluation function.

4. Procedure to Claim 3
**characterized in** that inputs/outputs that are not loaded by the interference quantity are closed through logical elements with defined EMC qualities or separated by means of a pulse inhibitor.

5. Procedure to Claim 3 or 4
**characterized in** that the operationally required sequence and the sequence that transmits the malfunctions to the outside are produced by the simulation unit (9) and at the generator (5), the interference quantity is increased until malfunctions occur in the sequence.

6. Procedure to any of the Claims 3 or 5
**characterized in** that the structural susceptibility for specific functional units of the IC and their special operation modes is evaluated using a pre-defined simulation Sequence and in order to enhance the confidence of the measurements the triggering of the interference pulses can be synchronized with the succession of the sequences whereby a control, or learning, respectively, effect can be used for the analysis and deliberate use of critical time periods of the measuring runs, and the interference generator (5) is synchronized with the simulation system (9).

7. Procedure to Claim 1
**characterized in** that for measurement of the overcoupling all outputs and all inputs (10) but the output (A) to be monitored, or only specific inputs and outputs are connected to the interference generator (5) and the interference current produces earth potential rises that are tapped from the output (A) using a reference input (RE) whereby the reference input (RE) has a defined gate susceptibility and a defined input resistance, and the earth potential rises are transformed by the reference input (RE), on exceeding the dynamic interference threshold, into logical signals and subsequently a pulse trap (2) captures, stretches and feeds these signals to an evaluation unit (3).

8. Procedure to Claim 1 and 7
**characterized in** that the interference current flows into the IC, but a component of it produces an interference voltage drop over an input (E) at a subsequent reference output (RA) and another input (RE) is connected in parallel to the reference output (RA) to which input the interference voltage also applies so that on exceeding the dynamic interference threshold the reference input (RE) transforms the interference voltage into an interference signal that is captured by the pulse trap (2).

9. Procedure to Claim 8
**characterized in** that a logical level is given by the reference output (RA).

10. Procedure to Claim 7 or 8
**characterized in** that a coupling over the outputs or the inputs or the outputs in tristate condition occurs.

11. Procedure to Claim 1
**characterized in** that for the evaluation of the field susceptibility on the base of pulsed magnetic fields, an induction coil (15) or induction loop is arranged over the chip (16) of the IC which coil or loop is loaded with a pulse-shaped interference current by which interference voltages are induced in the conductor loops of the chip (16) and the circuits of the chips are interferred whereby for the determination of chip regions with high susceptibility levels correspondingly small induction loops can be used.

12. Procedure to Claim 1, 5 or 6
**characterized in** that the external logical environment of the IC is simulated by a simulation unit (9).

13. Arrangement to execute the procedure to Claim 1 or 2
**characterized in** that for the measurement of the gate susceptibility of ICs with a complicated logical structure an interference generator (5) is connected via a coupling field to the corresponding input (10) of the IC and the inputs, or outputs (10), respectively, of the IC are assigned via a distributor (6) to an I/O unit (7) that also performs the function of a pulse trap (2) whereby the interference generator (5) is decoupled from the I/O unit (7) by a pulse inhibitor (8) that can be built as filter or inductance, and the functional elements interference generator (5), coupling field (4), distributor (6) and I/O unit (7) are linked to the simulation unit (9) with control and evaluation functions.

14. Arrangement to Claim 13
**characterized in** that only a specific type of IC can be used through a fixed logical wiring and in this case, the coupling field (4) and the distributor field (6) are not required.

## Revendications

1. Procédé pour évaluer les propriétés passives de tolérance électromagnétique de circuits intégrés en les sollicitant par des impulsions de contrôle qui sont produites par un générateur de parasites (5),
**caractérisé** en ce que les paramètres de tolérance électromagnétique du circuit intégré à évaluer se rattachent aux mécanismes d'action de l'influence du circuit intégré, et on mesure ainsi
a) la sensibilité de porte au moyen de l'influence de portes de base,
b) la sensibilité structurelle au moyen de l'influence de circuits logiques internes au circuit intégré,
c) le surcouplage au moyen de l'influence de circuits intégrés branchés en aval,
d) la sensibilité de champ au moyen de l'influence de champs externes au circuit intégré.

2. Procédé selon la revendication 1, **caractérisé** en ce qu'on détermine la sensibilité de porte en déterminant la zone de transition, sensible pour la résistance aux parasites, du seuil de perturbation statique au seuil de perturbation dynamique, à savoir la position de cette transition dans l'allure de courbe caractéristique, en appliquant à cet effet à l'entrée de porte (E), comme tension parasite de forme définie, une succession d'impulsions parasites dont les paramètres couvrent une plage du seuil de perturbation dynamique et de la transition vers le seuil de perturbation statique, et en transformant dans la porte (1), en cas de dépassement du seuil de perturbation, l'impulsion parasite en un signal logique qui est reçu à la sortie de porte (A) par un piège d'impulsions (2), le piège d'impulsions allongeant le signal et le transmettant pour son évaluation (3),
et en ce que l'impulsion parasite ou encore de contrôle individuelle présente la forme d'une impulsion exponentielle augmentant rapidement jusqu'à la valeur maximale ù, puis diminuant avec la constante de temps τ.

3. Procédé selon la revendication 1, **caractérisé** en ce que, pour mesurer la sensibilité structurelle, le courant parasite pulsé produit par un générateur de parasites est alimenté dans les entrées et/ou sorties (10) du circuit intégré, toutes ou seulement certaines des entrées et/ou sorties pouvant être alors utilisées, et le courant parasite, qui s'écoule vers l'extérieur par l'intermédiaire des structures internes du circuit intégré, principalement par l'intermédiaire des branchements de masse et de tension d'alimentation, produisant par l'intermédiaire de couplages inductifs, ohmiques et magnétiques des tensions parasites qui, à l'atteinte de phases critiques, peuvent engendrer la modification d'états logiques ou de séquences logiques de l'unité fonctionnelle respective (13), ce qui est enregistré, modifié et reporté par une unité de simulation (9) dotée de fonctions de commande et d'évaluation.

4. Procédé selon la revendication 3, **caractérisé** en ce que les entrées/sorties qui ne sont pas sollicitées par la grandeur perturbatrice sont fermées au moyen d'éléments logiques présentant des propriétés définies de tolérance électromagnétique, ou sont isolées par un barrage d'impulsions.

5. Procédé selon la revendication 3 ou 4, **caractérisé** en ce que l'unité de simulation (9) produit la séquence nécessaire pour l'exploitation et la séquence qui transmet les erreurs fonctionnelles vers l'extérieur, et la grandeur perturbatrice est alors augmentée au générateur (5) jusqu'à ce que des erreurs apparaissent dans la séquence.

6. Procédé selon la revendication 3 ou 5, **caractérisé** en ce que la détermination de la sensibilité structurelle pour des unités fonctionnelles logiques données du circuit intégré et leur mode particulier d'exploitation s'effectue en allouant une séquence définie de simulation,
et en ce que, afin d'augmenter la fiabilité de mesure, on peut effectuer une coordination du déclenchement des impulsions parasites avec la progression de la séquence, un effet de régulation ou encore d'apprentissage pouvant être employé pour l'analyse et l'utilisation dirigée de phases critiques des passes de mesure, et le générateur de parasites (5) étant synchronisé avec le système de simulation (9).

7. Procédé selon la revendication 1, **caractérisé** en ce que, afin de mesurer le surcouplage, toutes les entrées et toutes les sorties (10) à l'exception de la sortie (A) à surveiller, ou uniquement des entrées et sorties particulières, sont raccordées au générateur de parasites (5), et le courant parasite produit des augmentations du potentiel de masse qui sont prélevées à la sortie (A) par une entrée de référence (RE), l'entrée de référence (RE) possédant une sensibilité de porte définie et une résistance d'entrée définie, et les augmentations du potentiel de masse étant transformées en signaux logiques par l'entrée de référence (RE) en cas de dépassement du seuil de perturbation dynamique, et ces signaux étant ensuite reçus par un piège d'impulsions (2), allongés et apportés à un dispositif d'évaluation (3).

8. Procédé selon les revendications 1 et 7, **caractérisé** en ce que le courant parasite s'écoule dans le circuit intégré, mais une partie produit, en passant par une entrée (E), une chute de tension parasite à une sortie de référence (RA) branchée en aval, et une autre entrée (RE) est montée parallèlement à la sortie de référence (RA), entrée à laquelle s'applique également la tension parasite, de sorte qu'en cas de dépassement du seuil de perturbation dynamique, l'entrée de référence (RE) transforme la tension parasite en un signal parasite qui est reçu par le piège d'impulsions (2).

9. Procédé selon la revendication 8, **caractérisé** en ce qu'un niveau logique est alloué par la sortie de référence (RA).

10. Procédé selon la revendication 7 ou 8, **caractérisé** en ce que le couplage s'effectue par l'intermédiaire des sorties ou par l'intermédiaire des entrées ou par l'intermédiaire des sorties se trouvant en logique trois états.

11. Procédé selon la revendication 1, **caractérisé** en ce que, pour déterminer la sensibilité de champ sur la base de champs magnétiques pulsés, une bobine d'induction (15) ou boucle d'induction est disposée au-dessus de la puce (16) du circuit intégré et est sollicitée par un courant parasite pulsé, de sorte que des tensions parasites sont induites dans les boucles conductrices de la puce (16) et que les circuits de la puce subissent une influence, des boucles d'induction d'une petitesse correspondante pouvant être utilisées pour déterminer des régions de la puce de sensibilité élevée.

12. Procédé selon la revendication 1, 5 ou 6, **caractérisé** en ce que l'environnement logique externe du circuit intégré est reproduit par une unité de simulation (9).

13. Montage pour la mise en oeuvre du procédé selon la revendication 1 ou 2, **caractérisé** en ce que, pour mesurer la sensibilité de porte pour des circuits intégrés à structure logique compliquée, un générateur de parasites (5) est relié par l'intermédiaire d'un champ de couplage (4) à l'entrée correspondante (10) du circuit intégré, et les entrées ou sorties (10) du circuit intégré sont associées par l'intermédiaire d'un répartiteur (6) à une unité (7) d'entrée/sortie de données qui joue en même temps le rôle de piège d'impulsions (2), un barrage d'impulsions (8), qui peut être réalisé sous forme de filtre ou d'inductance, découplant le générateur de parasites (5) de l'unité (7) d'entrée/sortie de données, et les éléments fonctionnels suivants, générateur de parasites (5), champ de couplage (4), répartiteur (6) et unité (7) d'entrée/sortie de données, étant combinés avec une unité de simulation (9) dotée de fonctions de commande et d'évaluation.

14. Montage selon la revendication 13, **caractérisé** en ce qu'un seul type donné de circuit intégré peut être utilisé au moyen d'un câblage logique fixe et, dans ce cas, le champ de couplage (4) et le répartiteur (6) ne sont pas nécessaires.
